# EUROPÄISCHE PATENTSCHRIFT

(11) **EP 2 193 699 B1**
(45) Veröffentlichungstag und Bekanntmachung des Hinweises auf die Patenterteilung: **08.02.2017**
(21) Anmeldenummer: 08775333.1
(22) Anmeldetag: 24.07.2008
(51) Int. Cl.: H05K 5/06

(54) **VERFAHREN UND VORRICHTUNG ZUR HERSTELLUNG EINES GEHÄUSETEILS FÜR EIN STEUERGERÄT**
METHOD AND APPARATUS FOR PRODUCTION OF A HOUSING PART FOR A CONTROLLER
PROCÉDÉ ET DISPOSITIF POUR FABRIQUER UN ÉLÉMENT DE BOÎTIER POUR UN APPAREIL DE COMMANDE

(30) Priorität: 20.09.2007 DE 102007045157
(43) Veröffentlichungstag der Anmeldung: 09.06.2010
(73) Patentinhaber: Robert Bosch GmbH, 70442 Stuttgart (DE)
(72) Erfinder: GESELLMANN, Mirko, 72820 Sonnenbuehl-Genkingen (DE); HOLP, Reiner, 72474 Winterlingen (DE)
(86) Internationale Anmeldenummer: PCT/EP2008/059720
(87) Internationale Veröffentlichungsnummer: WO 2009/040160

(56) Entgegenhaltungen:
- EP-A- 1 581 037
- EP-A- 1 768 475
- WO-A-2007/101481
- DE-A1- 10 340 974
- US-B1- 7 209 360

## Beschreibung

Die Erfindung betrifft ein Gehäuseteil gemäß Anspruch 1, und ein Verfahren zur Herstellung des Gehäuseteiles gemäß Anspruch 2.

Die DE 103 40 974 A1 zeigt ein solches Gehäuseteil mit einem Rahmen aus zwei Teilen, die ineinander verschachtelt und beabstandet sind, und eine Bodenplatte. Die zwei Teile des Rahmens und die Bodenplatte begrenzen eine rechteckförmig verlaufende Nut. Leiterbahnen zwischen den Rahmenteilen durchqueren die Nut. Während der Herstellung sind die beiden Rahmenteile zunächst mittels der Leiterbahnen untereinander befestigt, ehe zur Stabilisierung eine Bodenplatte hinzugefügt wird.

Die WO 2007/101481 A beschreibt eine Gehäusevorrichtung für ein elektronisches Bauelement. Die Gehäusevorrichtung umfasst einen Gehäusegrundkörper und einen Rahmen, die eine gemeinsame Wandung aufweisen. Ein elektrischer Leiter ist in einem Gehäuseboden des Gehäusegrundkörpers eingegossen und darin rechtwinklig angeordnet. Aufgrund unterschiedlicher Ausdehnungskoeffizienten besteht die Möglichkeit, dass der Boden des Gehäusegrundkörpers Risse ausbildet und Flüssigkeit in den Gehäusegrundkörper eindringen kann.

Die US 7 209 360 B1 beschreibt eine Leiterplatine innerhalb eines Gehäuseinneren eines Gehäuses. Die Leiterplatine ist von dem Boden des Gehäuses beabstandet. Eine Kammer zwischen der Leiterplatine und dem Boden des Gehäuses ist mittels einer Harzmasse flüssigkeitsdicht verschlossen. Kühlrippen, die direkt auf der Leiterplatine angeordnet sind, ragen durch eine Öffnung des Gehäuses. Im Betriebszustand ist die Leiterplatine somit nicht gekapselt.

Die EP 1 581 037 A beschreibt eine Leiterplatine mit einem Deckel. Der Deckel weist Kontaktelemente auf. Eine Vergussmasse wird auf den Boden eines Gehäuses verbracht. Der Deckel mit der Leiterplatine wird so in das Gehäuse eingesetzt, dass ein unterer Teil der Leiterplatine in der Vergussmasse verklebt. Dieselbe Vergussmasse dient dazu, Deckel und Gehäuse untereinander abzudichten. Die Kontaktelemente durchdringen den Deckel. Eine Vergussmasse, die Deckel und Kontaktelemente untereinander abdichtet, ist nicht vorgesehen.

Die EP 1 768 475 A beschreibt ein Gehäuse für eine elektrische Schaltung. Das Gehäuse weist einen Deckel mit einer Kammer auf. Kontaktelemente einer Leiterplatine durchdringen den Deckel und die Kammer. Die Kammer ist mit einer Vergussmasse auffüllbar. Die Vergussmasse dichtet Deckel und Kontaktelemente ab. Eine Leiterplatine ist somit an dem Deckel angeordnet.

In einem Kraftfahrzeug sind teilweise mit einem isolierenden Kunststoff ummantelte elektrisch leitfähige Drähte verwendet, mittels derer ein Anlasser von einer Batterie mit Strom versorgbar ist. Dieser Strom wird lediglich kurzzeitig fließen, um den Motor des Kraftfahrzeuges zu starten. Die Zeitdauer des Stromflusses ist von einem Steuergerät bestimmt. Zwei elektrisch leitfähige Drähte führen von dem Steuergerät zu der Batterie und weitere zwei elektrisch leitfähige Drähte von dem Steuergerät zu dem Anlasser. Kontaktelemente, die in einem Gehäuseteil des Steuergerätes eingelassen sind, stellen eine elektrisch leitfähige Verbindung zwischen den elektrisch leitfähigen Drähten des Anlassers und der Batterie zu einer in dem Steuergerät angeordneten Leiterplatte her. Die elektronischen Bauteile auf der Leiterplatte und die Kontaktelemente erwärmen sich. Ebenso erwärmt sich das Gehäuseteil des Steuergerätes. Da die Kontaktelemente und das Gehäuseteil verschiedene Ausdehnungskoeffizienten aufweisen, bilden sich Risse und Spalten zwischen dem Gehäuseteil und den Kontaktelementen. Dadurch kann Schmutz und Feuchtigkeit in den Innenraum des Steuergerätes gelangen.

Der Erfindung liegt die Aufgabe zugrunde, ein einfaches Gehäuseteil mit Kontaktelementen für ein Steuergerät anzugeben, bei dem ein Eindringen von Schmutz und Feuchtigkeit verhindert ist. Ein einfaches Verfahren zur Herstellung des Gehäuseteils für das Steuergerät soll ebenfalls angegeben werden.

Diese Aufgaben werden mit den Merkmalen der Hauptansprüche gelöst. Erfindungsgemäß weist das Gehäuseteil eine erste und eine zweite Nut auf zwei einander abgewandten Oberflächen des Rahmens auf, die durch die beiden längeren Einfassungsteile und den kürzen Einfassungsteilen verlaufen, ist der Verlauf der beiden Nuten rechteckförmig ausgeprägt, Ist ein Nutgrund der ersten Nut einem zweiten Nutgrund der zweiten Nut abgewandt, stellen kleinere quaderförmige Ausnehmungen eine offene Verbindung zwischen den Nuten und hiermit Durchbrüche zwischen den Nuten her und ist das zumindest eine Kontaktelement so in das kürzere Einfassungsteil eingegossen, dass dieses in eine Leiterplattenausnehmung hineinragt und die kleinere Ausnehmung durchquert. Durch die zwei Nuten kann gegenüber zwei Platten abgedichtet werden. Das zumindest eine nach innen ragende Kontaktelement wird bei der Herstellung des Gehäuseteils zumindest teilweise ummantelt und ein flüssiges Dichtungsmaterial wird das zumindest eine nach innen ragende

Kontaktelement zumindest teilweise ummantelnd hinzugefügt. Das zumindest eine Kontaktelement wird innerhalb eines Werkzeuges so fixiert, dass das zumindest eine Kontaktelement innerhalb des Gehäuseteils eingegossen wird. Damit ist das zumindest eine Kontaktelement innerhalb des Gehäuseteils fixiert. Teile des Gehäuseteils ummanteln das zumindest eine Kontaktelement. Danach wird flüssiges Dichtungsmaterial so hinzugefügt, dass das flüssige Dichtungsmaterial das zumindest eine Kontaktelement zumindest teilweise so ummantelt, das ein Umfang des Kontaktelementes an einem Austritt aus dem Gehäuseteil umhüllt ist. Das flüssige Dichtungsmaterial erstarrt und dichtet damit einen Innenraum des Gehäuses an dem Austritt des Kontaktelementes aus dem Gehäuse gegenüber der äußeren Umgebung ab.

In vorteilhafter Weise wird das flüssige Dichtungsmaterial so hinzugefügt, dass ein zweites ansetzbares Gehäuseteil abgedichtet ist. Das Dichtungsmaterial ist so verwendet, dass einerseits ein Kontaktelement an einer Austrittsstelle aus dem Gehäuseteil ummantelt ist und andererseits das Dichtungsmaterial so an dem Gehäuseteil angeordnet ist, dass ein aufzusetzendes zweites Gehäuseteil abgedichtet ist. In einem Arbeitsgang wird ein Dichtungsmaterial so hinzugefügt, dass sowohl das Kontaktelement abgedichtet ist und das Dichtungsmaterial abdichtend zwischen zwei Gehäuseteilen angeordnet ist. Die Nut innerhalb des Gehäusetells Ist umlaufend und damit so ausgelegt, dass das Dichtungsmaterial gleichzeitig gegenüber einer auf dem Gehäuseteil aufzusetzenden Platte abdichtet. Die Durchbrüche werden nachfolgend auch als Ausnehmungen und das Dichtungsmaterial auch als Dichtmaterial, Dichtungsmasse oder Dichtmasse bezeichnet.

Die Vorrichtung zur Herstellung des Gehäuseteils ist in vorteilhafter Weise dadurch gekennzeichnet, dass das Gehäuseteil so in der Vorrichtung angeordnet ist, dass zumindest mittels einer Düse ein flüssiges Dichtungsmaterial in eine innerhalb des Gehäuseteiles oder der Vorrichtung verlaufenden Nut einspritzbar ist und das erstarrte Dichtungsmaterial einen Umfang des zumindest einen Kontaktelementes an einem Austritt aus dem Gehäuseteil umhüllt und das innerhalb der Nut erstarrte Dichtungsmaterial gegenüber zwei aufzusetzenden Teilen abdichtet. Auch bei einer Spaltenbildung zwischen Kontaktelement und Gehäuseteil ist ein Eindringen von Schmutz und Feuchtigkeit in einen Innenraum verhindert. Des weiteren ist das Gehäuseteil gegenüber einem auf dem Gehäuseteil aufzusetzenden zweitem Gehäuseteil abgedichtet. Solch ein aufzusetzendes Gehäuseteil ist eine Platte oder ein Gehäusedeckel.

In vorteilhafter Weise ist das Dichtungsmaterial ein Silikon. Das Silikon ist ein elastisches Dichtungsmaterial.

Zum besseren Verständnis der Erfindung ist nachfolgend ein Ausführungsbeispiel anhand der Zeichnung näher erläutert.

Es zeigen
- Fig. 1A: ein Gehäuseteil mit elektrisch leitfähigen Kontaktelementen in einer ersten perspektivischer Darstellung,
- Fig. 1B: das Gehäuseteil mit den elektrisch leitfähigen Kontaktelementen in einer zweiten perspektivischen Darstellung,
- Fig. 2A: das Gehäuseteil mit einer Grundplatte in einer ersten geschnittener Seitenansicht,
- Fig. 2B: das Gehäuseteil mit der Grundplatte in einer zweiten geschnittener Seitenansicht und
- Fig. 2C: das Gehäuseteil mit der Grundplatte in einer Teilansicht.

In den verschiedenen Figuren sind ähnliche oder dieselben Elemente durch gleiche Bezugszeichen bezeichnet.

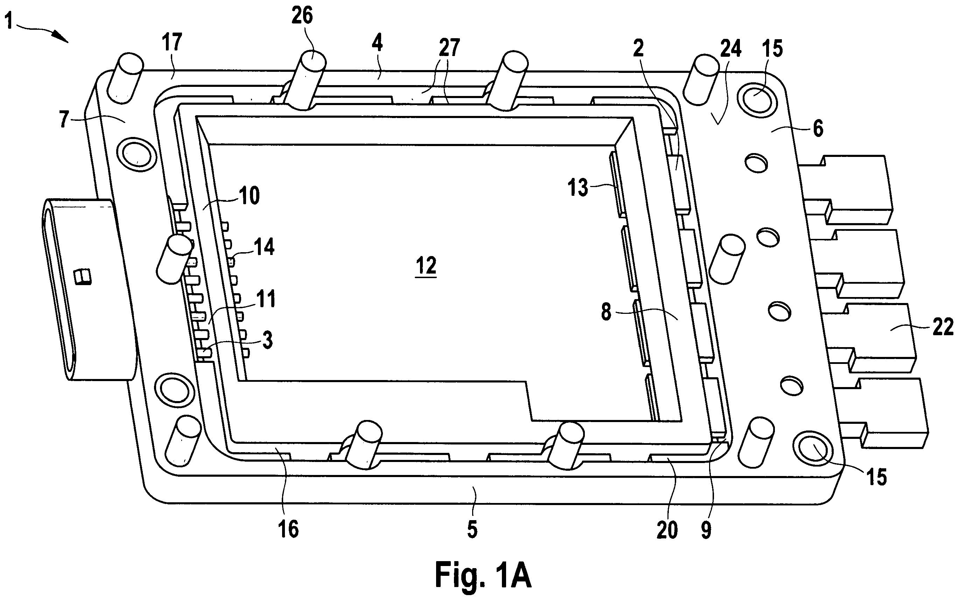

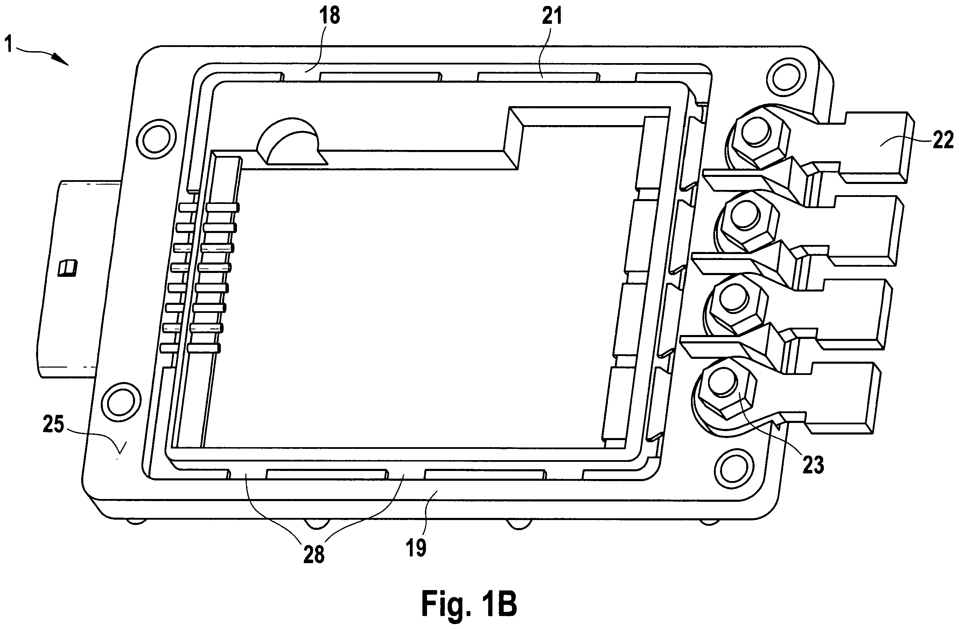

Figur 1A und 1B zeigen ein Kunststoffgehäuseteil 1 in Form eines Rahmens mit vier quaderförmigen Kontaktelementen 2, mittels derer eine elektrisch leitfähige Verbindung zu einem Anlasser und zu einer Batterie eines Kraftfahrzeuges herstellbar ist, und mit acht weiteren schmalen quaderförmigen Kontaktelementen 3, mittels derer eine elektrisch leitfähige Verbindung zu einer Motorsteuerung herstellbar ist. Das Gehäuseteil 1 ist einteilig mit einem ersten längeren Einfassungsteil 4, einem zweiten parallel dazu angeordneten längeren Einfassungsteil 5, einem senkrecht zu den längeren Einfassungsteilen 4 und 5 angeordneten ersten kürzeren Einfassungsteil 6 und einem parallel zu dem ersten kürzeren Einfassungsteil 6 angeordneten zweiten kürzeren Einfassungsteil 7 ausgeführt. Parallel zu dem ersten kürzeren Einfassungsteil 6 ist ein erster Steg 8 zwischen den längeren Einfassungsteilen 4 und 5 angeordnet. Die längeren Einfassungsteile 4 und 5, das erste kurze Einfassungsteil 6 und der erste Steg 8 begrenzen eine erste quaderförmige Ausnehmung 9. Das zweite kürzere Einfassungsteil 7 weist einen zweiten Steg 10 auf, der eine zweite kleinere quaderförmige Ausnehmung 11 begrenzt. Die längeren Einfassungsteile 4 und 5, das kurze Einfassungsteil 7 und der erste Steg 8 begrenzen eine größere quaderförmige Ausnehmung 12. Zwischen den längeren Einfassungsteilen 4 und 5, dem kurzen Einfassungsteil 7 und dem ersten Steg 8 ist eine Leiterplatte in der Ausnehmung 12 platzierbar. Diese Ausnehmung 12 ist nachfolgend als Leiterplattenausnehmung 12 bezeichnet. Die längeren Einfassungsteile 4 und 5, die kurzen Einfassungsteile 6 und 7 und die Stege 8 und 10 sind einteilig als Gehäuseteil 1 ausgeführt. Die vier quaderförmigen Kontaktelemente 2 sind so in dem ersten kürzeren Einfassungsteil 6 und dem Steg 8 des Gehäuseteils 1 eingegossen, dass diese in die Leiterplattenausnehmung 12 hineinragen und die kleinere Ausnehmung 9 zwischen dem ersten kurzen Einfassungsteil 6 und dem ersten Steg 8 durchqueren. In die Leiterplattenausnehmung 12 hineinragende Enden 13 der quaderförmigen Kontaktelemente 2 dienen dazu, um mittels elektrisch leitfähiger Drahtbügel einen elektrischen Kontakt zu elektronischen Bauteilen der Leiterplatte herzustellen. Die Kontaktelemente 2 ragen nach innen in einen Gehäuseinnenraum. Die acht stiftförmigen Kontaktelemente 3 sind so in dem zweiten kürzeren Einfassungsteil 7 und dem zweiten Steg 10 des Gehäuseteils 1 eingegossen, dass diese in die Leiterplattenausnehmung 12 hineinragen und die kleinere Ausnehmung 11 zwischen dem zweiten kurzen Einfassungsteil 7 und dem zweiten Steg 10 durchqueren. In die Leiterplattenausnehmung 12 hineinragende Enden 14 der stiftförmigen Kontaktelemente 3 dienen dazu, um mittels elektrisch leitfähiger Drahtbügel einen elektrischen Kontakt zu elektronischen Bauteilen der Leiterplatte herzustellen. Das Gehäuseteil 1 weist zylinderförmige Ausnehmungen 15 auf, die zur Befestigung des Steuergerätes in einem Motorraum des Kraftfahrzeuges dienen.

Das Gehäuseteil 1 weist eine erste Nut 16 auf, die durch die beiden längeren Einfassungsteile 4 und 5 und den kürzeren Einfassungsteilen 6 und 7 und zwischen dem ersten Steg 8 und dem ersten kurzen Einfassungsteil 6 verläuft. Die erste Nut 16 erstreckt sich über dem gesamten Gehäuseteil 1, der Verlauf der ersten Nut 16 ist somit rechteckförmig ausgeprägt. Ein Querschnitt der ersten Nut 16 ist rechteckförmig. Die erste Nut 16 verläuft in einer ersten Wandhälfte 17 des Gehäuseteils 1. Eine zweite Nut 18 verläuft in einer zweiten Wandhälfte 19 des Gehäuseteils 1. Diese zweite Nut 18 verläuft ebenfalls durch die beiden längeren Einfassungsteile 4 und 5 und den kürzeren Einfassungsteilen 6 und 7 und zwischen dem ersten Steg 8 und dem ersten kurzen Einfassungsteil 6. Die zweite Nut 18 erstreckt sich über dem gesamten Gehäuseteil 1, der Verlauf der zweiten Nut 18 ist ebenfalls rechteckförmig ausgeprägt. Ein Nutgrund 20 der ersten Nut 16 ist einem zweiten Nutgrund 21 der zweiten Nut 18 abgewandt. Ein zweiter Querschnitt der zweiten Nut 18 ist ebenfalls rechteckförmig. Die kleineren quaderförmigen Ausnehmungen 9 und 11 stellen eine offene Verbindung zwischen den Nuten 16 und 18 her, so dass erwärmtes flüssiges Dichtungsmaterial, mittels eines Werkzeuges an einer Stelle eingespritzt, innerhalb der Nuten 16 und 18 und der quaderförmigen Ausnehmungen 9 und 11 verläuft. Dabei liegt ein Werkzeug so an einander abgewandten Oberflächen 24 und 25 an, dass Nutöffnungen der Nuten 16 und 18 abgedichtet sind. Steckerhülsen 22, die Enden von elektrisch leitfähigen Drähten zu der Batterie und zu dem Anlasser umgreifen, sind mittels Schrauben 23 auf dem ersten kurzen Einfassungsteil 6 verschraubt und die Schrauben 23 stellen einen elektrischen Kontakt zu den Kontaktelementen 2 her. Von der ersten Oberfläche 24 aus erstrecken sich Zapfen 26. Einige der Zapfen 26 erstrecken sich aus der ersten Nut 16 heraus. Die Zapfen 26 sind so in die erste Nut 16 eingelassen, dass ein Abstand zu Nutwänden 27 gegeben ist und die Zapfen 26 bei aufgesetztem Werkzeug von dem flüssigen Dichtungsmaterial innerhalb der ersten Nut 16 umspülbar sind. Ausnehmungen 28 zwischen den Nuten 16 und 18 stellen eine offene Verbindung zwischen den Nuten 16 und 18 her, so dass flüssiges Dichtungsmaterial an eine Stelle einspritzt, innerhalb der Nuten 16 und 18 und der Ausnehmungen 9, 11 und 28 verteilbar ist.

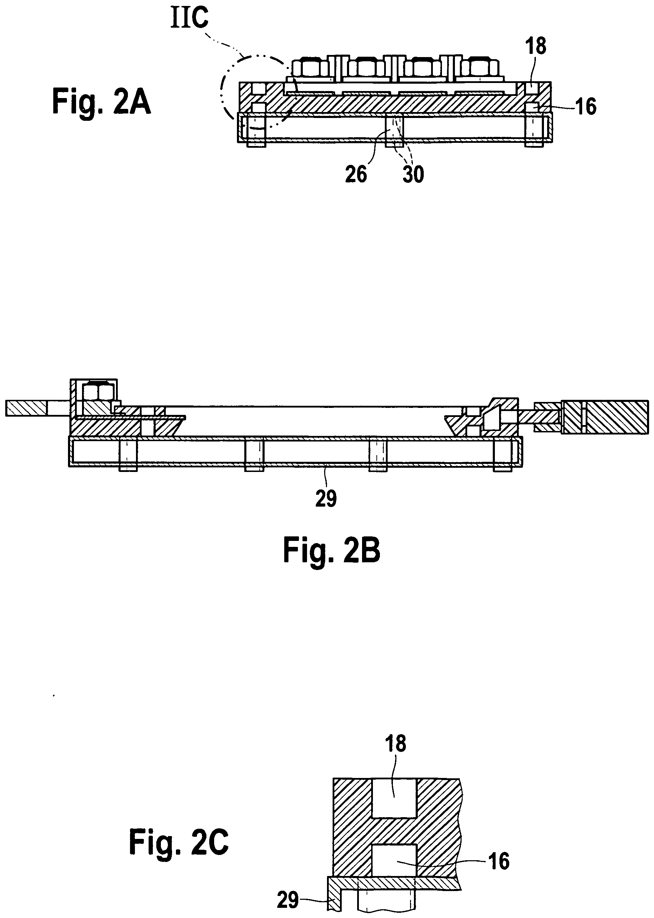

Figuren 2A, 2B und 2C zeigen das Gehäuseteil 1 und eine angesetzte Grundplatte 29. Die Grundplatte 29 wird auf dem Gehäuseteil 1 aufgesetzt. Die Zapfen 26 durchdringen zylinderförmige Ausnehmungen 30 der Grundplatte 29. Die Zapfen 26 werden erhitzt und so verformt, dass die Grundplatte 29 an dem Gehäuseteil 1 gehalten ist. Dieser Vorgang wird auch als warme Verformung oder als Verstemmung bezeichnet. Die Grundplatte 29 ist eine Aluminium Druckgussplatte.

## Patentansprüche

1. Gehäuseteil (1) für ein Steuergerät, das zumindest ein nach innen ragendes Kontaktelement (2, 3) aufweist und in Form eines Rahmens ist, wobei das Gehäuseteil einteilig mit einem ersten längeren Einfassungsteil (4), einem zweiten parallel dazu angeordneten längeren Einfassungsteil (5), einem senkrecht zu den längeren Einfassungsteilen (4 und 5) angeordneten ersten kürzeren Einfassungsteil (6) und einem parallel zu dem ersten kürzeren Einfassungsteil (6) angeordneten zweiten kürzeren Einfassungsteil (7) in Form eines Rahmens ausgeführt ist, wobei das Gehäuseteil (1) eine erste und eine zweite Nut (16, 18) auf zwei einander abgewandten Oberflächen des Rahmens aufweist, die durch die beiden längeren Einfassungsteile (4, 5) und den kürzen Einfassungsteilen (6, 7) verlaufen, der Verlauf der beiden Nuten (16, 18) rechteckförmig ausgeprägt ist, ein Nutgrund (20) der ersten Nut (16) einem zweiten Nutgrund (21) der zweiten Nut (18) abgewandt ist, kleinere quaderförmige Ausnehmungen (9, 11) die eine offene Verbindung zwischen den Nuten (16, 18) und hiermit Durchbrüche zwischen den Nuten (16, 18) herstellen und das zumindest eine Kontaktelement (2, 3) so in das kürzere Einfassungsteil (6 , 7) eingegossen ist, dass dieses in eine Leiterplattenausnehmung (12) hineinragt und die kleinere Ausnehmung (9, 11) durchquert.

2. Verfahren zur Herstellung eines Gehäuseteils (1) nach Anspruch 1, **dadurch gekennzeichnet, dass** mittels einer Düse ein flüssiges Dichtungsmaterial in eine Nut (16) eingespritzt wird und derartig erstarrt, dass das erstarrte Dichtungsmaterial einen Umfang des zumindest einen Kontaktelementes (2, 3) an einem Austritt aus dem Gehäuseteil (1) umhüllt und das innerhalb der Nuten (16, 18) erstarrte Dichtungsmaterial gegenüber zwei aufzusetzenden Teilen (29) abdichtet.

3. Verfahren nach Anspruch 2, **dadurch gekennzeichnet, dass** das Dichtungsmaterial ein Silikon ist.

## Claims

1. Housing part (1) for a control device, which housing part has at least one inwardly projecting contact element (2, 3) and is in the form of a frame, wherein the housing part is integrally formed with a first relatively long mount part (4), a second relatively long mount part (5), which is arranged parallel to the said first relatively long mount part, a first relatively short mount part (6), which is arranged perpendicular to the relatively long mount parts (4 and 5), and a second relatively short mount part (7), which is arranged parallel to the first relatively short mount part (6), in the form of a frame, wherein the housing part (1) has a first and a second groove (16, 18) on two surfaces of the frame which are averted from one another, which grooves run through the two relatively long mount parts (4, 5) and the short mount parts (6, 7), the profile of the two grooves (16, 18) is rectangular, a groove base (20) of the first groove (16) is averted from a second groove base (21) of the second groove (18), relatively small cuboidal recesses (9, 11), which establish an open connection between the grooves (16, 18) and as a result apertures between the grooves (16, 18), and the at least one contact element (2, 3) is incorporated into the relatively short mount part (6, 7) such that the said contact element protrudes into a printed circuit board recess (12) and crosses the relatively small recess (9, 11).

2. Method for producing a housing part (1) according to Claim 1, **characterized in that** a liquid sealing material is injected into a groove (16) by means of a nozzle and solidifies in such a way that the solidified sealing material encloses a circumference of the at least one contact element (2, 3) at an outlet out of the housing part (1) and the sealing material which is solidified within the grooves (16, 18) provides sealing with respect to two parts (29) which are to be mounted.

3. Method according to Claim 2, **characterized in that** the sealing material is a silicone.

## Revendications

1. Partie de boîtier (1) pour un contrôleur, laquelle possède au moins un élément de contact (2, 3) faisant saillie vers l'intérieur et étant sous la forme d'un premier cadre; la partie de boîtier étant réalisée d'une seule pièce sous la forme d'un cadre avec une première partie d'encadrement plus longue (4), une deuxième partie d'encadrement plus longue (5) disposée parallèlement à celle-ci, une première partie d'encadrement plus courte (6) disposée perpendiculairement aux parties d'encadrement plus longues (4 et 5) et une deuxième partie d'encadrement plus courte (7) disposée parallèlement à la première partie d'encadrement plus courte (6), la partie de boîtier (1) possédant une première et une deuxième rainure (16, 18) sur deux surfaces du cadre opposées l'une à l'autre, lesquelles s'étendent à travers les deux parties d'encadrement plus longues (4, 5) et les parties d'encadrement courtes (6, 7), le tracé des deux rainures (16, 18) étant marqué parallélépipédique, un fond de rainure (20) de la première rainure (16) se trouvant à l'opposé à un deuxième fond de rainure (21) de la deuxième rainure (18), de petites cavités (9, 11) en forme de quadrilatère, lesquelles établissement une liaison ouverte entre les rainures (16, 18) et ainsi des traversées entre les rainures (16, 18), et l'au moins un élément de contact (2, 3) étant scellé dans les parties d'encadrement plus courtes (6, 7) de telle sorte que celui-ci fait saillie dans une cavité de circuit imprimé (12) et passe transversalement à travers les petites cavités (9, 11).

2. Procédé de fabrication d'une partie de boîtier (1) selon la revendication 1, **caractérisé en ce qu'**un matériau d'étanchéité est injecté dans une rainure (16) au moyen d'une buse et se solidifie de telle sorte que le matériau d'étanchéité solidifié enveloppe un pourtour de l'au moins un élément de contact (2, 3) au niveau d'une sortie hors de la partie de boîtier (1) et le matériau d'étanchéité solidifié à l'intérieur des rainures (16, 18) réalise l'étanchéité par rapport à deux parties (29) à poser.

3. Procédé selon la revendication 2, **caractérisé en ce que** le matériau d'étanchéité est un silicone.
